# EUROPEAN PATENT SPECIFICATION

(11) **EP 3 610 516 B1**
(45) Date of publication and mention of the grant of the patent: **23.06.2021**
(21) Application number: 18717668.0
(22) Date of filing: 04.04.2018
(51) Int. Cl.: H01L 31/054, H01L 31/052, E04C 1/42

(54) **CONSTRUCTION BLOCK WITH PHOTOVOLTAIC DEVICE**
KONSTRUKTIONSBLOCK MIT PHOTOVOLTAIKVORRICHTUNG
BLOC DE CONSTRUCTION COMPRENANT UN DISPOSITIF PHOTOVOLTAÏQUE

(30) Priority: 11.04.2017 GB 201705840
(43) Date of publication of application: 19.02.2020
(73) Proprietor: University of Exeter, Exeter, Devon EX4 4QJ (GB)
(72) Inventor: BAIG, Hasan, Penryn Cornwall TR10 9FE (GB); MALLICK, Tapas, Penryn Cornwall TR10 9FE (GB); WILLIAMS, James, Morgan, Penryn Cornwall TR10 9TA (GB)
(74) Representative: Appleyard Lees IP LLP
(86) International application number: PCT/GB2018/050905
(87) International publication number: WO 2018/189509

(56) References cited:
- EP-A1- 2 040 312
- WO-A2-2007/149001
- DE-A1- 10 306 529
- DE-A1-102008 030 652
- DE-U1- 29 823 351
- DE-U1-202011 110 117

## Description

This invention relates to a construction block for use in a building, the block being of transparent, light transmissive form, and which includes a photovoltaic device to permit the generation of electricity.

The use of transparent, typically glass, blocks in buildings to form internal partitions whilst allowing light to pass through the partitions, or in the formation of sections of external walls which allow the transmission of light therethrough is well known. Such blocks are sometimes of solid glass form, but other arrangements in which the blocks are of hollow form are also known, such arrangements being advantageous in that they are of reduced weight and material cost.

The incorporation of photovoltaic cells into or onto building structures to allow the generation of electricity is also well known. By way of example, large photovoltaic panels are often located upon or incorporated into the roofs of buildings or are mounted upon the external walls of buildings.

Arrangements are known in which photovoltaic panels or cells are incorporated into glass blocks, alongside rechargeable batteries or the like and electrically operable light emitting devices such as light emitting diodes to form a solar powered light which may be incorporated into a structure, for example in the walls or floors thereof. However, in arrangements of this type, the panels or cells and other components substantially prevent the passage or transmission of light completely through the block, and so such devices are unsuitable for use in the formation of light transmitting wall or floor sections.

Large solar cells are usually of opaque form and so incorporation of such panels or cells into a transparent block would prevent the block from allowing the transmission of light from one surface thereof to another. Clearly, therefore, the incorporation of large solar cells into transparent blocks intended for use in the construction of a light transmitting region or section of a wall, floor or partition is not appropriate.

Arrangements are known in which solar collector devices are used to allow smaller dimension photovoltaic devices to be used and so allowing a quantity of light to pass completely through the block. Such arrangements allow the generation of electricity whilst being suitable for use in the construction of a light transmissive partition.

Where used in part of an exterior wall of a building, it is desirable for a transparent block to not only allow the transmission of light between opposing surfaces thereof in order to achieved the desired function of admitting light to the building, but also for the block to be of good thermal insulating properties so as to avoid significantly negatively impacting upon the overall thermal insulating properties of the building in which they are used. Known arrangements are of relatively poor thermal insulating properties and so are unsuitable for use in such applications.

WO2007/149001 describes a glass roof tile designed in such a manner as to allow the harvesting of solar energy.

It is an object of the invention to provide a block suitable for use in such applications and in which at least some of the disadvantages associated with known blocks are overcome or are of reduced effect.

According to the present invention there is provided a block as defined by appended Claim 1.

It will be appreciated that in such an arrangement, as the photovoltaic device is mounted upon a solar concentrator, it need not be of large dimensions. Consequently, a significant quantity of light is able to pass the photovoltaic device, passing from the input wall to the output wall, and so the block is suitable for use in applications in which it is desired to allow light to enter a building, whilst still allowing electrical energy to be generated. By providing projections which disrupt the formation of convection currents in the void, the thermal insulating properties of the block are enhanced.

The arrangement is advantageous in that the formation of convection currents is significantly disrupted, in use, by the projections.

At least one of the input wall and the output wall preferably has a peripheral wall formed integrally therewith, the peripheral wall extending towards the other of the input wall and the output wall. Preferably, peripheral walls are associated with both the input wall and the output walls, the peripheral walls engaging one another to space the input wall and the output wall apart from one another, the input wall, the output wall and the peripheral walls together defining the void. The peripheral walls may be cold fused to one another. However, if desired, other securing techniques may be used.

The projections may be arranged in a regular array. However, other patterns may be used, if desired.

When viewed from the input wall, the parts of the block formed with the solar concentrator(s) and photovoltaic device(s) will appear as dark spots or regions. By appropriate positioning of the projections, a desired visual appearance may be achieved. For example, the dark spots may be arranged to give the appearance of dark lines. If desired, certain of the projections may have no photovoltaic device associated therewith. Instead, they may have a coloured element associated therewith, with the result that the block appears to have coloured spots or regions thereon or therein. Again, by appropriate location of the projections, a desired visual appearance may be achieved.

The outer face of the input wall may be shaped to include domed regions aligned with the projections. The domed regions may serve to increase the angle of incidence with which light is able to enter the projections.

The output wall may be patterned to provide a desired visual effect. By way of example, it may be textured to provide an obscure glazed effect. Alternatively, through the use of coloured elements mounted upon the projections the block may give the effect of a series of coloured spots or pixels.

Where a plurality of photovoltaic devices is present, they are conveniently connected together, and output conductors from the devices are preferably arranged to pass from the block, for example through an opening formed in the output wall or between the input and output walls.

The projections may take a range of forms. Where serving as solar concentrators, they are preferably shaped in such a manner as to define an input side of, for example, substantially circular or elliptical shape and an output side of, for example, substantially square or rectangular shape. Whilst the aforementioned shapes are convenient, other shapes may be used. By way of example, the input and/or output sides may be of polygonal shape such as being of hexagonal shape, or they may be of non-regular shape. The photovoltaic device is preferably of substantially the same dimensions as the output side. The input sides of adjacent ones of the solar concentrators are preferably spaced apart from one another.

Between the input and output sides of the solar concentrators, the projections are preferably shaped to define side walls of curved form. For example, they may be of a hyperbolic curved form. The curved form of the side walls is advantageous in that the solar concentrators allow light from a wide range of angles of incidence upon the input side to be transmitted to the output side. By way of example, the range of angles of incidence may be as large as approximately 150°. In contrast, where flat sided projections are used, the range of angles of incidence may be as low as 2°.

The invention will further be described, by way of example, with reference to the accompanying drawings, in which:
Figure 1 is a front view of a construction block in accordance with an embodiment of the invention;
Figure 2 is a side view of the block of Figure 1;
Figure 3 is a cross-sectional view through the block of Figure 1;
Figure 4 is a perspective view illustrating part of the block of Figure 1;
Figure 5 is a series of views illustrating example projection layouts;
Figures 6a to 6c are views illustrating a modified embodiment of the invention; and
Figures 7a and 7b illustrate another embodiment.

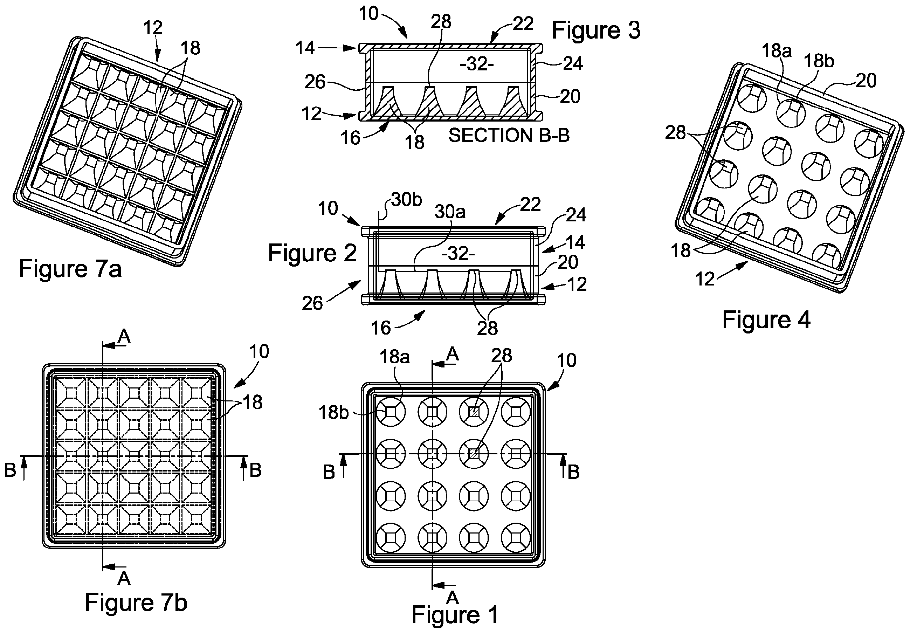

Referring firstly to Figures 1 to 4 of the accompanying drawings, a construction block 10 is illustrated, the block 10 being of substantially transparent form, being largely manufactured of a transparent glass material. The block 10 is intended for use in the formation of light transmitting sections of walls in buildings. These sections may take the form of internal partitions or floors, or parts thereof, but the block is especially suitable for use in external walls, being of good thermal insulating properties as described herein. The block 10 is not intended to bear significant loads, in use, and so typically a lintel or the like will be located above the section to support higher parts of the building.

The block 10 comprises a front section 12 and a rear section 14, both of which are of moulded glass form. The front section 12 is shaped to define an input wall 16 which, in use, faces towards the exterior of the building. Formed integrally with the input wall 16 are a series of projections 18. Around the periphery of the input wall 16 is integrally formed a peripheral wall 20. As shown in Figures 2 and 3, the peripheral wall 20 is of slightly greater height than the projections 18 in this embodiment.

In the arrangement shown, the outer surface of the input wall 16 is of slightly dished form so that a central part thereof is spaced inwardly compared to peripheral parts thereof.

The rear section 14 comprises an output wall 22 and an integral peripheral wall 24. The rear section 14 is thus of similar form to the front section 12 with the exception that the rear section 14 does not include the projections 18.

As illustrated, the input and output walls 16, 22 are of substantially square form, the corners thereof being slightly rounded. However, the invention is not restricted in this regard and a range of other shapes are possible. By way of example, blocks 10 of rectangular form are possible without departing from the scope of the invention. Similarly, the blocks 10 could be of hexagonal or triangular form, such shapes being advantageous in that they tessellate. However, the invention is not restricted in this regard, and the blocks could be of other shapes such as of circular cross sectional shape.

As shown in Figures 2 and 3, the peripheral walls 20, 24 are spaced inwardly from the edges of the input and output walls 16, 22 such that in the finished product a shallow channel 26 extends around the block 10. Depending upon the construction technique used in the formation of the light transmitting wall section, this channel may contain, in use, an adhesive material used to secure or bond the blocks 10 in position, and/or it may contain parts of a mounting frame or the like. The manner in which the blocks 10 are fixed in position, in use, is not of relevance to the present invention and so will not be described in further detail herein.

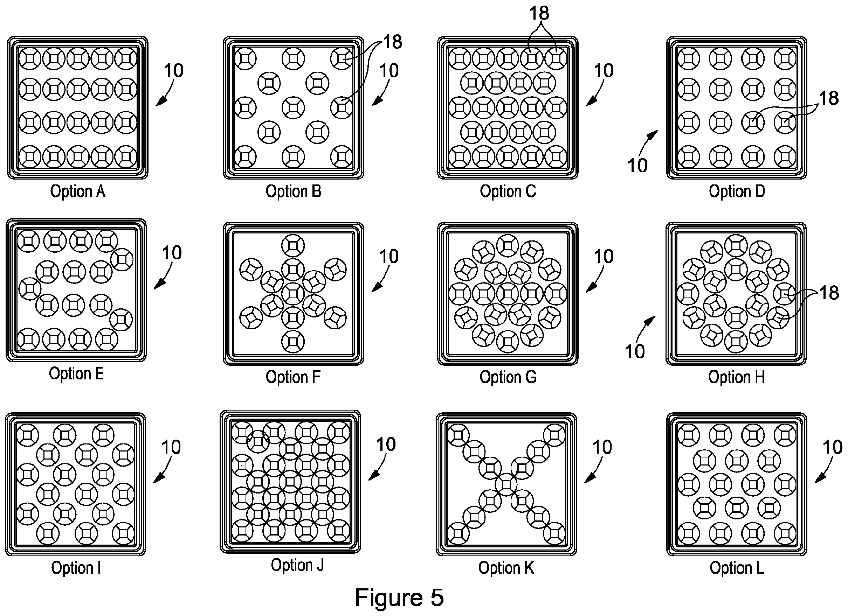

In the arrangement illustrated, each of the projections 18 takes the form of a solar concentrator, each projection 18 being shaped to include an input side 18a of substantially elliptical or circular form (circular in the arrangement shown in Figures 1 to 4) and an output side 18b of square or rectangular form (square in the arrangement shown in Figures 1 to 4), and side walls of curved, hyperbolic form extending between the input side 18a and the output side 18b. The shape of the projections 18 is such that light incident upon the input side 18a undertakes multiple internal reflections and is concentrated upon the output side 18b. The shape allows light from a wide range of angles of incidence, for example in the region of 150°, to pass from the input side 18a to the output side 18b. This is advantageous as sunlight will be able to pass to the output side 18b for the majority of daylight hours. The precise shape of the solar concentrator may depend upon the position and orientation in which the block is to be mounted to maximise the incidence of light at the output side 18b. Whilst specific shapes for the projection 18 are illustrated, it will be appreciated that the invention is not restricted in this regard. The side walls could be of, for example, parabolic form or of linear form, the input sides may be of, for example, circular form (as shown in Figure 5), or of polygonal form, for example, and the output side may be of square shape (as shown in Figure 5) or of a range of other shapes. Figures 7a and 7b illustrate an arrangement in which the input sides 18a are of square shape. In the arrangement of Figures 7a and 7b, the projections 18 are relatively closely packed, only small spaces being present therebetween. However, it will be appreciated that they may be spaced further apart, if desired, and may be arranged to form a desired pattern in a manner similar to those shown in Figure 5.

The projections 18 are shaped such that the areas of the output sides 18b, together, make up considerably less than 10% of the area of the output wall 22. Consequently, from the output wall side of the block 10, the block 10 will have a bright, light appearance when light is incident upon the input wall thereof.

Mounted upon the output side 18b of each projection is a respective photovoltaic device 28. The devices 28 may take a range of forms, but are conveniently of silicon solar cell technology having a performance in the region of 20-25%. Such materials are relatively low in cost. Conveniently, the devices 28 are permanently mounted in position upon the output sides 18b of the projections 18, for example by means of an appropriate adhesive. The devices 28 are arranged such that the light incident thereon causes the generation of an electrical output, and conductors 30a are provided which interconnect the devices 28, conductors 30b being provided by which the electrical output can be supplied, via an opening formed in the output wall 22 to the exterior of the block 10, from where it may be supplied to a remote location, if desired.

With the devices 28 and conductors 30a, 30b correctly mounted in position, the front and rear sections 12, 14 are secured to one another with the free edges of the peripheral wall 20 of the front section 10 abutting the free edges of the peripheral wall 24 of the rear section 14. In this position, the free edges are cold fused to one another, or are otherwise secured to one another to form the finished block.

As illustrated, the projections 18 extend to a location spaced from the input wall 16 by a spacing that is greater than 25% of the distance between the input wall 16 and the output wall 22. Indeed, the spacing preferably falls in the range 30 to 60% of the said distance, and in the arrangement shown is approximately 45% of the distance. By arranging for the projections 18 to project from the input wall 16 by a significant distance, it will be appreciated that the formation of convection currents in the air (or other gas) located in the void 32 defined between the front and rear sections 12, 14 is disrupted. By disrupting the formation of convection currents, thermal energy losses between the output wall 22 and the input wall 16 are reduced, and so the thermal insulating properties of the block 10 are enhanced. However, by ensuring that the projections 18 stop significantly short of the output wall 22, conduction of thermal energy between the input and output walls 16, 22 is restricted or avoided. Again, therefore, the thermal insulating properties of the block 10 are enhanced as a result.

In use, where a light transmitting wall section is constructed using blocks 10 of the form described hereinbefore, some of the light incident on the input wall 16 will be transmitted between the input wall 16 and the output wall 22, with the result that light is able to enter the building through the light transmitting wall section. Additionally, some of the light incident upon the input wall 16, in the region of the input sides 18a of the projections 18, will be incident upon the photovoltaic devices 28 with the result that an electrical output is generated, to be output from the block 10 via the conductors 30. The block 10 thus serves to allow light to enter the building whilst also serving to generate electricity. As described above, the presence of the projections 18 extending from the input wall 16 within the void 32 serves to disrupt the formation of convection currents in the air within the void 32, and so enhances the thermal insulating properties of the block 10.

When viewed from the input wall side of the block 10, the presence of the devices 28, which are typically of dark coloured form, viewed through the projections 18 results in the block 10 appearing to have a series of dark spots or regions thereon, each of the input sides 18a appearing as a dark spot or region. As, in the arrangement illustrated, the projections 18 are arranged as a regular array, the dark spots or regions appear as a regular array on or in the block 10. If desired, the projections may be arranged to achieve a desired pattern or visual appearance, for example to form lines or other patterns. Figure 5 is a series of views illustrating a number of other possible layouts. It will be appreciated that these are merely examples, and that the invention also encompasses a number of other layouts.

Whilst in the arrangement illustrated each projection 18 has a device 28 mounted thereon, if desired one or more of the projections could instead have a coloured material element mounted thereon so that, when viewed from the input wall side, the block 10 would appear to have one or more coloured spots or regions thereon or therein. The colours may be chosen depending upon the intended use of the block, and the positions of the projections 18, and hence of the spots or regions, may be selected, as mentioned above, to achieve a desired visual impression.

Similarly, when viewed from the output wall 22, the presence of the devices 28 and/or coloured elements may result in the block 10 having a patterned visual appearance, and by appropriate positioning of the projections 18, devices 28 and coloured elements, a desired visual appearance may be achieved. If desired, the output wall 22 may be textured to provide an obscure glazed or misted appearance, for example, and/or may be of coloured or tinted form.

In the arrangement shown, the input wall 16 adjacent input sides 18a is substantially planar. To increase the angles of incidence by which light may enter the projections 18, domed regions may be incorporated into the input wall 16, aligned with each input side 18a.

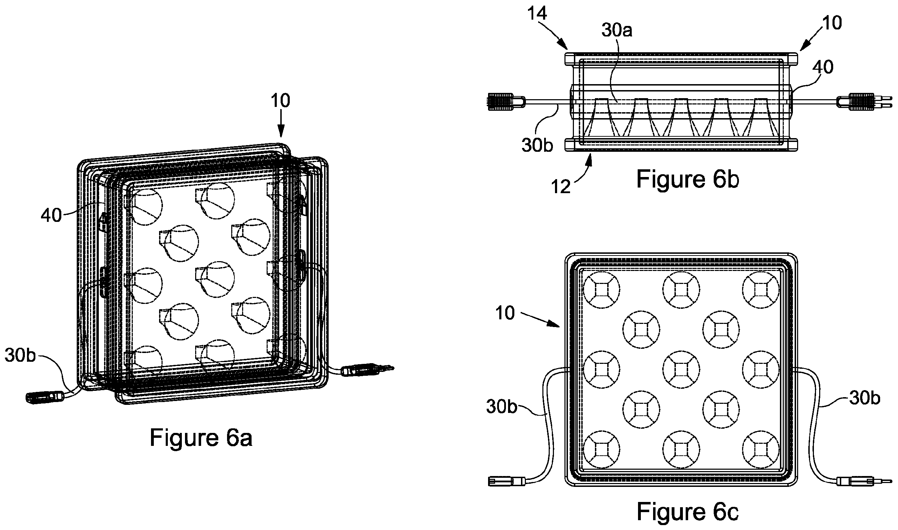

Figures 6a to 6c illustrate an alternative design. In the arrangement of Figures 6a to 6c, rather than directly fuse the sections 12, 14 to one another, an intermediate frame member 40 is located therebetween through which the output conductor 30b extends. As shown, the conductors 30b are provided with connectors to allow a series of the blocks 10 to be electrically connected to one another
It will be appreciated that whilst specific arrangements are described herein, a number of modifications and alterations may be made to the block without departing from the scope of the invention as defined by the appended claims.

## Claims

1. A transparent, light transmissive block comprising an input wall (16) and an output wall (22) spaced apart from the input wall (16), a void (32) being formed between the input wall (16) and the output wall (22), wherein the input wall (16) has a plurality of projections (18) formed integrally therewith, the projections (18) extending toward the output wall (22) and serving to disrupt convention currents forming in the void (32), at least one of the projections (18) comprising a solar concentrator which has a photovoltaic device (28) mounted thereon, **characterised in that** the projections (18) extend to positions spaced from the input wall (16) by 30-60% of the spacing between the input wall (16) and the output wall (22).

2. A block according to Claim 1, where at least one of the input wall (16) and the output wall (22) has a peripheral wall (20) formed integrally therewith, the peripheral wall (20) extending towards the other of the input wall (16) and the output wall (22).

3. A block according to Claim 2, wherein peripheral walls (20) are associated with both the input wall (16) and the output wall (22), the peripheral walls (20) engaging one another to space the input wall (16) and the output wall (22) apart from one another, the input wall (16), the output wall (22) and the peripheral walls (20) together defining the void (32).

4. A block according to any of the preceding claims, wherein the projections (18) are arranged in a regular array.

5. A block according to any of the preceding claims, wherein the outer face of the input wall (16) is shaped to include domed regions aligned with the projections (18).

6. A block according to any of the preceding claims, wherein at least one of the projections (18) is shaped in such a manner as to define an input side of substantially circular, elliptical, square or rectangular shape and an output side of substantially square or rectangular shape.

7. A block according to Claim 6, wherein the photovoltaic device (28) is of substantially the same dimensions as the output side.

8. A block according to Claim 6 or Claim 7, wherein the input sides of adjacent ones of the solar concentrators are spaced apart from one another.

9. A block according to any of the preceding claims, wherein the input wall (16) and the output wall (22) are of square, rectangular, hexagonal or triangular shape.

## Patentansprüche

1. Transparenter, lichtdurchlässiger Block, umfassend eine Eingangswand (16) und eine Ausgangswand (22), welche von der Eingangswand (16) beabstandet ist, wobei ein Hohlraum (32) zwischen der Eingangswand (16) und der Ausgangswand (22) gebildet ist, wobei die Eingangswand (16) eine Vielzahl von Vorsprüngen (18) aufweist, welche einstückig damit gebildet sind, wobei die Vorsprünge (18) sich in Richtung der Ausgangswand (22) erstrecken und dazu dienen, Konvektionsströme zu unterbrechen, welche sich in dem Hohlraum (32) bilden, wobei mindestens einer der Vorsprünge (18) einen Solarkonzentrator umfasst, welcher eine daran montierte Photovoltaikvorrichtung (28) aufweist, **dadurch gekennzeichnet, dass** die Vorsprünge (18) sich zu Positionen erstrecken, welche von der Eingangswand (16) um 30 bis 60 % des Abstandes zwischen der Eingangswand (16) und der Ausgangswand (22) beabstandet sind.

2. Block nach Anspruch 1, wobei mindestens eine von der Eingangswand (16) und der Ausgangswand (22) eine einstückig damit gebildete umlaufende Wand (20) aufweist, wobei die umlaufende Wand (20) sich in Richtung der anderen der Eingangswand (16) und der Ausgangswand (22) erstreckt.

3. Block nach Anspruch 2, wobei umlaufende Wände (20) gleichermaßen mit der Eingangswand (16) und der Ausgangswand (22) assoziiert sind, wobei die umlaufenden Wände (20) miteinander in Eingriff gehen, um die Eingangswand (16) und die Ausgangswand (22) voneinander zu beabstanden, wobei die Eingangswand (16), die Ausgangswand (22) und die umlaufenden Wände (20) gemeinsam den Hohlraum (32) definieren.

4. Block nach einem der vorhergehenden Ansprüche, wobei die Vorsprünge (18) in einer regelmäßigen Anordnung angeordnet sind.

5. Block nach einem der vorhergehenden Ansprüche, wobei die äußere Seite der Eingangswand (16) in einer Weise geformt ist, dass sie gewölbte Bereiche einschließt, welche auf die Vorsprünge (18) ausgefluchtet sind.

6. Block nach einem der vorhergehenden Ansprüche, wobei mindestens einer der Vorsprünge (18) in einer Weise geformt ist, dass er eine Eingangsseite von im Wesentlichen kreisförmiger, elliptischer, quadratischer oder rechteckiger Form, und eine Ausgangsseite von im Wesentlichen quadratischer oder rechteckiger Form definiert.

7. Block nach Anspruch 6, wobei die Photovoltaikvorrichtung (28) im Wesentlichen dieselben Abmessungen aufweist wie die Ausgangsseite.

8. Block nach Anspruch 6 oder 7, wobei die Eingangs seiten von aneinandergrenzenden der Solarkonzentratoren voneinander beabstandet sind.

9. Block nach einem der vorhergehenden Ansprüche, wobei die Eingangswand (16) und die Ausgangswand (22) von quadratischer, rechteckiger, sechseckiger oder dreieckiger Form sind.

## Revendications

1. Bloc transparent, transmettant la lumière, comprenant une paroi d'entrée (16) et une paroi de sortie (22) espacée de la paroi d'entrée (16), un vide (32) étant formé entre la paroi d'entrée (16) et la paroi de sortie (22), dans lequel la paroi d'entrée (16) comporte une pluralité de saillies (18) formées de façon solidaire avec celle-ci, les saillies (18) s'étendant vers la paroi de sortie (22) et servant à perturber des courants de convection se formant dans le vide (32), au moins l'une des saillies (18) comprenant un concentrateur solaire qui comporte un dispositif photovoltaïque (28) monté sur celui-ci, **caractérisé en ce que** les saillies (18) s'étendent jusqu'à des positions espacées de la paroi d'entrée (16) de 30 à 60 % de l'espacement entre la paroi d'entrée (16) et la paroi de sortie (22).

2. Bloc selon la revendication 1, dans lequel au moins l'une de la paroi d'entrée (16) et de la paroi de sortie (22) comporte une paroi périphérique (20) formée solidairement avec celle-ci, la paroi périphérique (20) s'étendant vers l'autre de la paroi d'entrée (16) et de la paroi de sortie (22).

3. Bloc selon la revendication 2, dans lequel des parois périphériques (20) sont associées à la fois avec la paroi d'entrée (16) et la paroi de sortie (22), les parois périphériques (20) se mettant en prise l'une dans l'autre pour espacer la paroi d'entrée (16) et la paroi de sortie (22) l'une de l'autre, la paroi d'entrée (16), la paroi de sortie (22) et les parois périphériques (20) définissant ensemble le vide (32).

4. Bloc selon l'une quelconque des revendications précédentes, dans lequel les saillies (18) sont agencées selon un réseau régulier.

5. Bloc selon l'une quelconque des revendications précédentes, dans lequel la face extérieure de la paroi d'entrée (16) est formée pour inclure des régions en forme de dôme alignées avec les saillies (18).

6. Bloc selon l'une quelconque des revendications précédentes, dans lequel au moins l'une des saillies (18) est formée de manière à définir un côté d'entrée de forme sensiblement circulaire, elliptique, carrée ou rectangulaire et un côté de sortie de forme sensiblement carrée ou rectangulaire.

7. Bloc selon la revendication 6, dans lequel le dispositif photovoltaïque (28) a sensiblement les mêmes dimensions que le côté de sortie.

8. Bloc selon la revendication 6 ou 7, dans lequel les côtés d'entrée de concentrateurs solaires adjacents parmi les concentrateurs solaires sont espacés l'un de l'autre

9. Bloc selon l'une quelconque des revendications précédentes, dans lequel la paroi d'entrée (16) et la paroi de sortie (22) sont d'une forme carrée, rectangulaire, hexagonale ou triangulaire.
